# EUROPEAN PATENT APPLICATION

(11) **EP 4 788 090 A1**
(43) Date of publication of application: **05.08.2026**
(21) Application number: 25168798.4
(22) Date of filing: 07.04.2025
(51) Int. Cl.: H10D 89/60, H10D 86/00

(54) **ESD CIRCUIT HAVING BURIED OXIDE DEVICE**

(30) Priority: 03.02.2025 US 202519043527
(71) Applicant: MEDIATEK INC., Hsinchu City 30078 (TW)
(72) Inventor: CHEN, Chun-Cheng, 30078 Hsinchu City (TW); HUANG, Bo-Shih, 30078 Hsinchu City (TW)
(74) Representative: Haseltine Lake Kempner LLP

(57) **Abstract**

The present invention provides an ESD protection circuit including a BOX device and at least one ESD device. The BOX device includes a BOX layer placed between a substrate and an active silicon layer, and the BOX device and the ESD device are connected in cascode. The ESD protection circuit has a higher trigger voltage and will not be falsely triggered, and an active layer of the BOX device does not form any parasitic paths with the underlying layers.

## Description

### BACKGROUND

Many integrated circuits in electronic products are manufactured using high-voltage (HV) processes, such as automotive ICs. Compared to low-voltage (LV) components, high-voltage transistors have more complex structures. This complexity is designed to expand the operating range and breakdown voltage, which makes electrostatic discharge (ESD) protection design more challenging and difficult. In high-voltage ESD protection design, lateral diffused MOS (LDMOS) transistors are commonly used. However, when using LDMOS for ESD circuit, the operating voltage of the I/O pins needs to be limited to prevent the I/O pin voltage from exceeding the trigger voltage of the LDMOS, which could cause the LDMOS to enable and affect the operation of the internal circuit.

### SUMMARY

It is therefore an objective of the present invention to provide an ESD protection circuit, which can increase the trigger voltage of the ESD device without causing any adverse effects, to solve the above-mentioned problems.

According to one embodiment of the present invention, an ESD protection circuit comprising a buried oxide (BOX) device and at least one ESD device is disclosed. The BOX device comprises a BOX layer placed between a substrate and an active silicon layer, and the BOX device and the ESD device are connected in cascode.

According to one embodiment of the present invention, a chip comprising an internal circuit, a pad and an ESD protection circuit is disclosed. The pad is used for communications between the internal circuit and an external device. The ESD protection circuit comprises a BOX device and at least one ESD device, wherein the BOX device comprises a BOX layer placed between a substrate and an active silicon layer, and the BOX device and the ESD device are connected in cascode.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG. 1 is a diagram illustrating a chip according to one embodiment of the present invention.
FIG. 2 shows a cross-sectional view of the NMOS with BOX layer and the NFOD.
FIG. 3 is a diagram showing an I-V curve of the NMOS with BOX layer and the NFOD, and an I-V current of the NFOD according to one embodiment of the present invention.
FIG. 4 is a diagram illustrating a chip according to one embodiment of the present invention.
FIG. 5 is a diagram illustrating a chip according to one embodiment of the present invention.
FIG. 6 is a diagram illustrating a chip according to one embodiment of the present invention.
FIG. 7 is a diagram illustrating a chip according to one embodiment of the present invention.
FIG. 8 is a diagram illustrating a chip according to one embodiment of the present invention.
FIG. 9 is a diagram illustrating a chip according to one embodiment of the present invention.
FIG. 10 is a diagram illustrating a chip according to one embodiment of the present invention.
FIG. 11 is a diagram illustrating a chip according to one embodiment of the present invention.

### DETAILED DESCRIPTION

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

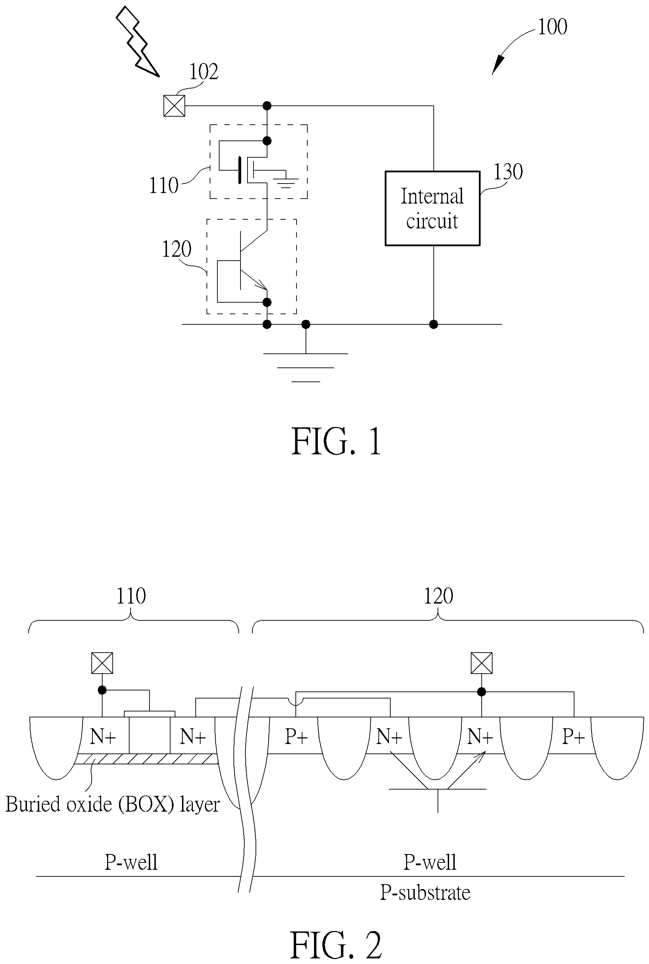

FIG. 1 is a diagram illustrating a chip 100 according to one embodiment of the present invention. As shown in FIG. 1, the chip 100 comprises a pad 102, an ESD protection circuit and an internal circuit 130. The pad 102 is coupled to an external device, and the internal circuit 130 receives a signal from the external device via the pad 102, and/or the internal circuit transmits a signal to the external device via the pad 102. The ESD protection circuit is coupled between the pad 102 and a ground voltage, and the ESD protection circuit is configured to provide a current path from the pad 102 to the ground when a voltage at the pad 102 is higher than a threshold voltage.

In this embodiment, the ESD protection circuit comprises a buried oxide device (BOX device) and an ESD device. In this embodiment, the BOX device is implemented by a diode-connected N-type metal-oxide semiconductor (NMOS) 110 with BOX layer (i.e., gate electrode is connected to drain electrode), and the ESD device is implemented by an N-type field oxide device (NFOD) 120, wherein the NMOS 110 with BOX layer and the NFOD 120 are connected in cascode. FIG. 2 shows a cross-sectional view of the NMOS 110 with BOX layer and the NFOD 120. As shown in FIG. 2, the BOX layer is a component manufactured by the Silicon-On- Insulator (SOI) technology, and it is a thin layer of silicon dioxide (SiO2) placed between the silicon substrate (e.g., P-well or P-substrate in FIG. 2) and the active silicon layer (e.g., N-type doping, N+, in FIG. 2). The BOX layer in the NMOS 110 can provide electrical isolation between the active silicon layer and the underlying bulk silicon substrate, and this isolation reduces parasitic capacitance, reduces leakage currents and minimizes the impact of substrate noise on the device's performance.

In this embodiment, the BOX device (i.e., the NMOS 110) can be the active device in the ESD protection circuit closest to the pad 102, and it can also be the first active device viewed from the pad 102 of the chip 100.

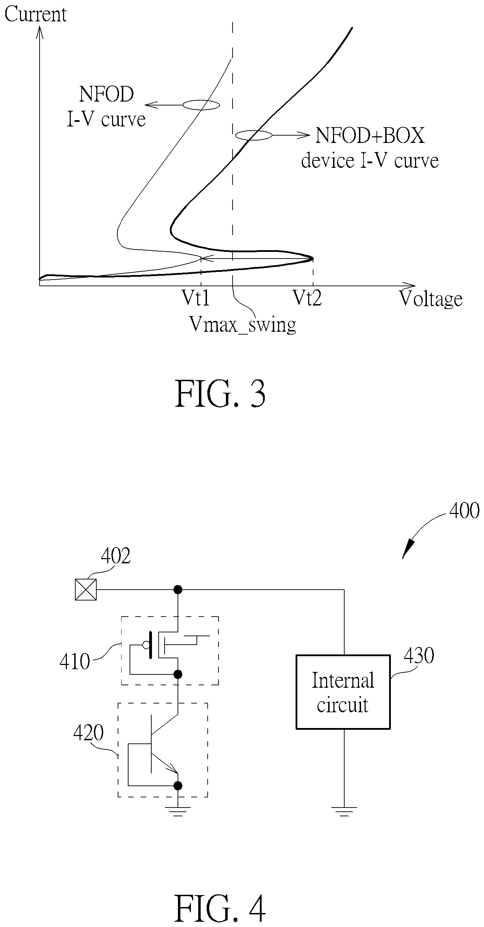

FIG. 3 is a diagram showing a current-voltage curve (I-V curve) of the NMOS 110 with BOX layer and the NFOD 120, and an I-V current of the NFOD according to one embodiment of the present invention. As shown in FIG. 3, if the ESD protection circuit only comprises the NFOD, there is a possibility that the maximum voltage swing Vmax_swing of the signal at pad 102 exceeds the trigger voltage Vt1 of the NFOD, causing the ESD protection circuit to be triggered and generate a current path, which could affect the signals transmitted or received by the internal circuit 130. If the ESD protection circuit comprises the NMOS 110 with BOX layer and the NFOD 120, the trigger voltage Vt2 of the ESD protection circuit is increased to above the maximum voltage swing Vmax_swing of the signal at pad 102, so that the ESD protection circuit will not be falsely triggered, thereby preventing any impact on the operation of the internal circuit 130.

In addition, because of the BOX layer of the NMOS 110, the active layer of the NMOS 110 does not form any parasitic paths with the underlying layers, the likelihood of unexpected device breakdown occurrences can be reduced.

FIG. 4 is a diagram illustrating a chip 400 according to one embodiment of the present invention. As shown in FIG. 4, the chip 400 comprises a pad 402, an ESD protection circuit and an internal circuit 430. The pad 402 is coupled to an external device, and the internal circuit 430 receives a signal from the external device via the pad 402, and/or the internal circuit transmits a signal to the external device via the pad 402. The ESD protection circuit is coupled between the pad 402 and a ground voltage, and the ESD protection circuit is configured to provide a current path from the pad 402 to the ground when a voltage at the pad 402 is higher than a threshold voltage. The ESD protection circuit comprises a BOX device and an ESD device. In this embodiment, the BOX device is implemented by a diode-connected P-type metal-oxide semiconductor (PMOS) 410 with BOX layer, and the ESD device is implemented by an NFOD 420, wherein the PMOS 410 with BOX layer and the NFOD 420 are connected in cascode. Similar to the embodiment shown in FIG. 1, the ESD protection circuit having the PMOS 410 with BOX layer and an NFOD 420 has a higher trigger voltage and will not be falsely triggered, and the active layer of the PMOS 410 does not form any parasitic paths with the underlying layers, so that the operation of the internal circuit 430 will not be influenced and the likelihood of unexpected device breakdown occurrences can be reduced.

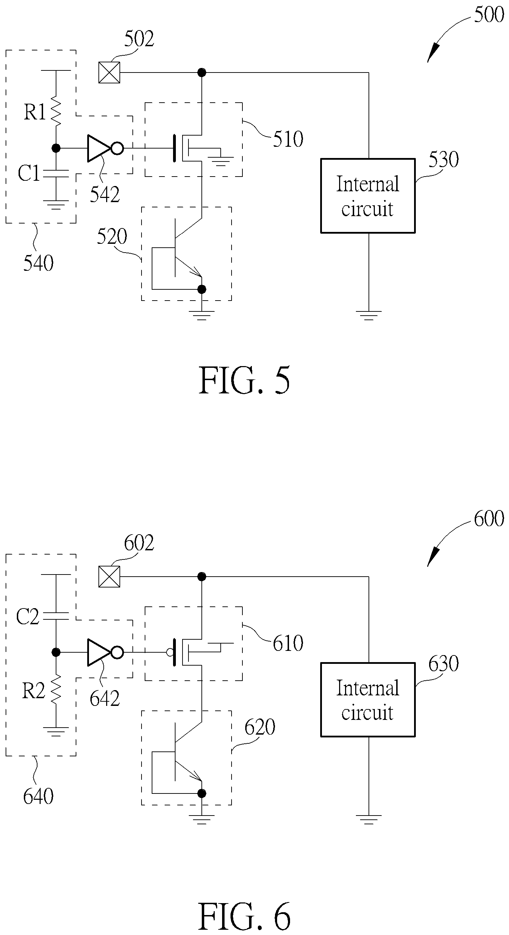

FIG. 5 is a diagram illustrating a chip 500 according to one embodiment of the present invention. As shown in FIG. 5, the chip 500 comprises a pad 502, an ESD protection circuit and an internal circuit 530. The pad 502 is coupled to an external device, and the internal circuit 530 receives a signal from the external device via the pad 502, and/or the internal circuit transmits a signal to the external device via the pad 502. The ESD protection circuit is coupled between the pad 502 and a ground voltage, and the ESD protection circuit is configured to provide a current path from the pad 502 to the ground when a voltage at the pad 502 is higher than a threshold voltage. The ESD protection circuit comprises a BOX device, an ESD device and a trigger circuit 540. In this embodiment, the BOX device is implemented by a diode-connected NMOS 510 with BOX layer, the ESD device is implemented by an NFOD 520, wherein the NMOS 510 with BOX layer and the NFOD 520 are connected in cascode. In addition, the trigger circuit 540 comprises a resistor R1, a capacitor C1 and an inverter 542 coupled between a node (e.g., a node connecting to the pad 502) and the ground voltage, and the trigger circuit 540 is configured to generate a trigger signal to a gate of the NMOS 510. Similar to the embodiment shown in FIG. 1, the ESD protection circuit having the NMOS 510 with BOX layer and an NFOD 520 has a higher trigger voltage and will not be falsely triggered, and the active layer of the NMOS 510 does not form any parasitic paths with the underlying layers, so that the operation of the internal circuit 530 will not be influenced and the likelihood of unexpected device breakdown occurrences can be reduced.

FIG. 6 is a diagram illustrating a chip 600 according to one embodiment of the present invention. As shown in FIG. 6, the chip 600 comprises a pad 602, an ESD protection circuit and an internal circuit 630. The pad 602 is coupled to an external device, and the internal circuit 630 receives a signal from the external device via the pad 602, and/or the internal circuit transmits a signal to the external device via the pad 602. The ESD protection circuit is coupled between the pad 602 and a ground voltage, and the ESD protection circuit is configured to provide a current path from the pad 602 to the ground when a voltage at the pad 602 is higher than a threshold voltage. The ESD protection circuit comprises a BOX device, an ESD device and a trigger circuit 640. In this embodiment, the BOX device is implemented by a diode-connected PMOS 610 with BOX layer, the ESD device is implemented by an NFOD 620, wherein the PMOS 610 with BOX layer and the NFOD 620 are connected in cascode. In addition, the trigger circuit generator 640 comprises a resistor R2, a capacitor C2 and an inverter 642 coupled between a node (e.g., a node connecting to the pad 602) and the ground voltage, and the bias voltage generator 640 is configured to generate a trigger signal to a gate of the PMOS 610. Similar to the embodiment shown in FIG. 1, the ESD protection circuit having the PMOS 610 with BOX layer and an NFOD 620 has a higher trigger voltage and will not be falsely triggered, and the active layer of the PMOS 610 does not form any parasitic paths with the underlying layers, so that the operation of the internal circuit 630 will not be influenced and the likelihood of unexpected device breakdown occurrences can be reduced.

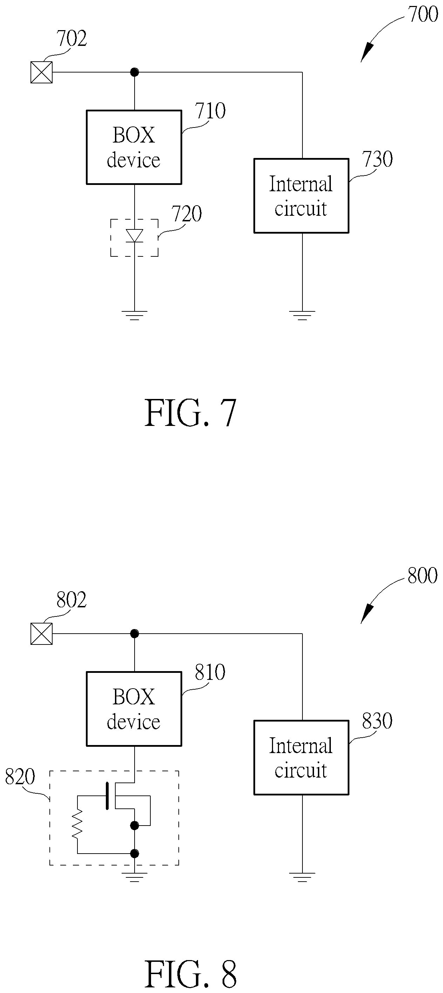

FIG. 7 is a diagram illustrating a chip 700 according to one embodiment of the present invention. As shown in FIG. 7, the chip 700 comprises a pad 702, an ESD protection circuit and an internal circuit 730. The pad 702 is coupled to an external device, and the internal circuit 730 receives a signal from the external device via the pad 702, and/or the internal circuit transmits a signal to the external device via the pad 702. The ESD protection circuit is coupled between the pad 702 and a ground voltage, and the ESD protection circuit is configured to provide a current path from the pad 702 to the ground when a voltage at the pad 702 is higher than a threshold voltage. The ESD protection circuit comprises a BOX device 710 and an ESD device. In this embodiment, the BOX device 710 can be NMOs or PMOS with BOX layer, and the ESD device is a diode 720, wherein the BOX device 710 and the diode 720 are connected in cascode. Similar to the embodiment shown in FIG. 1, the ESD protection circuit having the BOX device 710 and the diode 720 has a higher trigger voltage and will not be falsely triggered, and the active layer of the BOX device 710 does not form any parasitic paths with the underlying layers, so that the operation of the internal circuit 730 will not be influenced and the likelihood of unexpected device breakdown occurrences can be reduced.

FIG. 8 is a diagram illustrating a chip 800 according to one embodiment of the present invention. As shown in FIG. 8, the chip 800 comprises a pad 802, an ESD protection circuit and an internal circuit 830. The pad 802 is coupled to an external device, and the internal circuit 830 receives a signal from the external device via the pad 802, and/or the internal circuit transmits a signal to the external device via the pad 802. The ESD protection circuit is coupled between the pad 802 and a ground voltage, and the ESD protection circuit is configured to provide a current path from the pad 802 to the ground when a voltage at the pad 802 is higher than a threshold voltage. The ESD protection circuit comprises a BOX device 810 and an ESD device. In this embodiment, the BOX device 810 can be NMOs or PMOS with BOX layer, and the ESD device is a NMOS 820 on bulk, wherein the BOX device 810 and the NMOS 820 are connected in cascode. Similar to the embodiment shown in FIG. 1, the ESD protection circuit having the BOX device 810 and the NMOS 820 has a higher trigger voltage and will not be falsely triggered, and the active layer of the BOX device 810 does not form any parasitic paths with the underlying layers, so that the operation of the internal circuit 830 will not be influenced and the likelihood of unexpected device breakdown occurrences can be reduced.

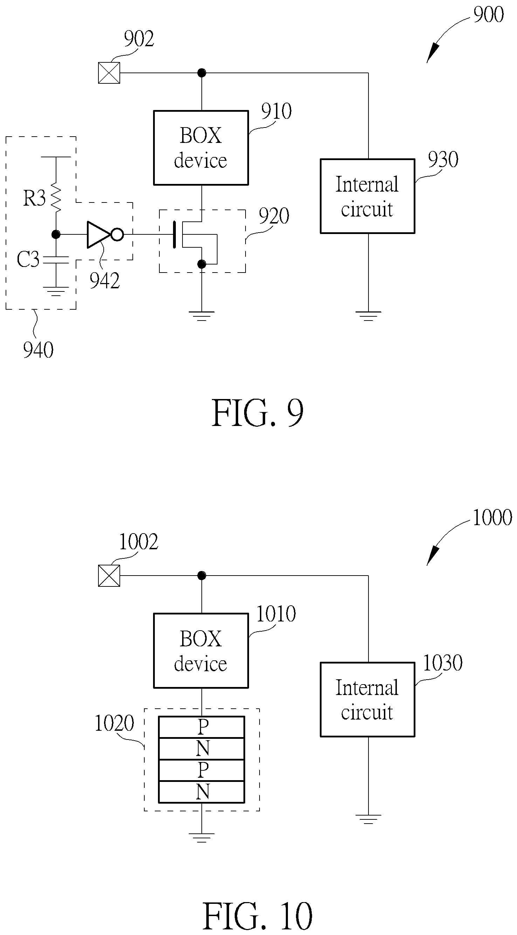

FIG. 9 is a diagram illustrating a chip 900 according to one embodiment of the present invention. As shown in FIG. 9, the chip 900 comprises a pad 902, an ESD protection circuit and an internal circuit 930. The pad 902 is coupled to an external device, and the internal circuit 930 receives a signal from the external device via the pad 902, and/or the internal circuit transmits a signal to the external device via the pad 902. The ESD protection circuit is coupled between the pad 902 and a ground voltage, and the ESD protection circuit is configured to provide a current path from the pad 902 to the ground when a voltage at the pad 902 is higher than a threshold voltage. The ESD protection circuit comprises a BOX device 910, an ESD device and a trigger circuit 940. In this embodiment, the BOX device can be NMOs or PMOS with BOX layer, and the ESD device is a NMOS 920 on SOI, wherein the BOX device 910 and the NMOS 920 are connected in cascode. The trigger circuit generator 940 comprises a resistor R3, a capacitor C3 and an inverter 942 coupled between a node (e.g., a node connecting to the pad 902) and the ground voltage, and the bias voltage generator 940 is configured to generate a trigger signal to a gate of the NMOS 920. Similar to the embodiment shown in FIG. 1, the ESD protection circuit having the BOX device 910 and the NMOS 920 has a higher trigger voltage and will not be falsely triggered, and the active layer of the BOX device 910 does not form any parasitic paths with the underlying layers, so that the operation of the internal circuit 930 will not be influenced and the likelihood of unexpected device breakdown occurrences can be reduced.

FIG. 10 is a diagram illustrating a chip 1000 according to one embodiment of the present invention. As shown in FIG. 10, the chip 1000 comprises a pad 1002, an ESD protection circuit and an internal circuit 1030. The pad 1002 is coupled to an external device, and the internal circuit 1030 receives a signal from the external device via the pad 1002, and/or the internal circuit transmits a signal to the external device via the pad 1002. The ESD protection circuit is coupled between the pad 1002 and a ground voltage, and the ESD protection circuit is configured to provide a current path from the pad 1002 to the ground when a voltage at the pad 1002 is higher than a threshold voltage. The ESD protection circuit comprises a BOX device 1010 and an ESD device. In this embodiment, the BOX device 1010 can be NMOs or PMOS with BOX layer, and the ESD device is a silicon controlled rectifier (SCR) 1020, wherein the BOX device 1010 and the SCR 1020 are connected in cascode. Similar to the embodiment shown in FIG. 1, the ESD protection circuit having the BOX device 1010 and the SCR 1020 has a higher trigger voltage and will not be falsely triggered, and the active layer of the BOX device 1010 does not form any parasitic paths with the underlying layers, so that the operation of the internal circuit 1030 will not be influenced and the likelihood of unexpected device breakdown occurrences can be reduced.

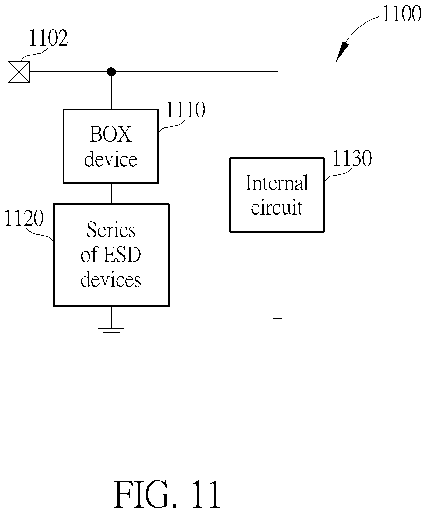

FIG. 11 is a diagram illustrating a chip 1100 according to one embodiment of the present invention. As shown in FIG. 11, the chip 1100 comprises a pad 1102, an ESD protection circuit and an internal circuit 1130. The pad 1102 is coupled to an external device, and the internal circuit 1130 receives a signal from the external device via the pad 1102, and/or the internal circuit transmits a signal to the external device via the pad 1102. The ESD protection circuit is coupled between the pad 1102 and a ground voltage, and the ESD protection circuit is configured to provide a current path from the pad 1102 to the ground when a voltage at the pad 1102 is higher than a threshold voltage. The ESD protection circuit comprises a BOX device 1110 and a series of ESD devices 1120. In this embodiment, the BOX device 1110 can be NMOs or PMOS with BOX layer, and the series of ESD devices comprises at least a portion of FODs, diodes, PMOSs, NMOSs, PMOS on SOI, NMOS on SOI, and SCR, wherein the BOX device 1110 and the series of ESD devices 1120 are connected in cascode. Similar to the embodiment shown in FIG. 1, the ESD protection circuit having the BOX device 1110 and the series of ESD devices 1120 has a higher trigger voltage and will not be falsely triggered, and the active layer of the BOX device 1110 does not form any parasitic paths with the underlying layers, so that the operation of the internal circuit 1130 will not be influenced and the likelihood of unexpected device breakdown occurrences can be reduced.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An electrostatic discharge, ESD, protection circuit, comprising:
a buried oxide, BOX, device (710, 810, 910, 1010, 1110), wherein the BOX device (710, 810, 910, 1010, 1110) comprises a BOX layer placed between a substrate and an active silicon layer; and
at least one ESD device (110, 120, 420, 510, 520, 620, 720, 820, 920, 1020), wherein the BOX device (710, 810, 910, 1010, 1110) and the ESD device (110, 120, 420, 510, 520, 620, 720, 820, 920, 1020) are connected in cascode.

2. The ESD protection circuit of claim 1, wherein the ESD protection circuit is a positioned within a chip (100, 400, 500, 600, 700, 800, 900, 1000, 1100), and the chip (100, 400, 500, 600, 700, 800, 900, 1000, 1100) comprise a pad (102, 402, 502, 602, 702, 802, 902, 1002, 1102) used for communications between an internal circuit (130, 430, 530, 630, 730, 830, 930, 1030, 1130) and an external device; and the BOX device (710, 810, 910, 1010, 1110) is an active device in the ESD protection circuit closest to the pad (102, 402, 502, 602, 702, 802, 902, 1002, 1102) of the chip (100, 400, 500, 600, 700, 800, 900, 1000, 1100).

3. The ESD protection circuit of claim 2, wherein the BOX device (710, 810, 910, 1010, 1110) is a first active device viewed from the pad (102, 402, 502, 602, 702, 802, 902, 1002, 1102) of the chip (100, 400, 500, 600, 700, 800, 900, 1000, 1100).

4. The ESD protection circuit of claim 1, wherein the BOX device (710, 810, 910, 1010, 1110) is an N-type metal-oxide semiconductor, NMOS, (110, 510, 820, 920), with BOX layer or a P-type metal-oxide semiconductor, PMOS, (410, 610), with the BOX layer, and the at least one ESD device (120, 420, 520, 620) comprises an N-type field oxide device, NFOD.

5. The ESD protection circuit of claim 4, wherein the BOX device (710, 810, 910, 1010, 1110) is the diode-connected NMOS (110, 510, 820, 920) with BOX layer or the diode-connected PMOS (410, 610) with the BOX layer.

6. The ESD protection circuit of claim 4, wherein the ESD protection circuit is a positioned within a chip (100, 400, 500, 600, 700, 800, 900, 1000, 1100), and the chip (100, 400, 500, 600, 700, 800, 900, 1000, 1100) comprise a pad (102, 402, 502, 602, 702, 802, 902, 1002, 1102) used for communications between an internal circuit (130, 430, 530, 630, 730, 830, 930, 1030, 1130) and an external device; and a gate electrode of the NMOS (110, 510, 820, 920) or a gate electrode of the PMOS (410, 610) is connected to a trigger circuit (540, 640, 940), wherein the trigger circuit (540, 640, 940) is coupled to the pad (102, 402, 502, 602, 702, 802, 902, 1002, 1102) of the chip (100, 400, 500, 600, 700, 800, 900, 1000, 1100).

7. The ESD protection circuit of claim 1, wherein the at least one ESD device (720) comprises a diode.

8. The ESD protection circuit of claim 1, wherein the at least one ESD device (110, 510, 820, 920) comprises an NMOS.

9. The ESD protection circuit of claim 1, wherein the at least one ESD device (1020) comprises a silicon controlled rectifier, SCR.

10. A chip (100, 400, 500, 600, 700, 800, 900, 1000, 1100), comprising:
an internal circuit (130, 430, 530, 630, 730, 830, 930, 1030, 1130);
a pad (102, 402, 502, 602, 702, 802, 902, 1002, 1102), used for communications between the internal circuit (130, 430, 530, 630, 730, 830, 930, 1030, 1130) and an external device; and
an electrostatic discharge, ESD, protection circuit comprising a buried oxide, BOX, device (710, 810, 910, 1010, 1110) and at least one ESD device (110, 120, 420, 510, 520, 620, 720, 820, 920, 1020), wherein the BOX device (710, 810, 910, 1010, 1110) comprises a BOX layer placed between a substrate and an active silicon layer, and the BOX device (710, 810, 910, 1010, 1110) and the ESD device (110, 120, 420, 510, 520, 620, 720, 820, 920, 1020) are connected in cascode.

11. The chip (100, 400, 500, 600, 700, 800, 900, 1000, 1100) of claim 10, wherein the BOX device (710, 810, 910, 1010, 1110) is an active device in the ESD protection circuit closest to the pad (102, 402, 502, 602, 702, 802, 902, 1002, 1102) of the chip (100, 400, 500, 600, 700, 800, 900, 1000, 1100).

12. The chip (100, 400, 500, 600, 700, 800, 900, 1000, 1100) of claim 11, wherein the BOX device (710, 810, 910, 1010, 1110) is a first active device viewed from the pad (102, 402, 502, 602, 702, 802, 902, 1002, 1102) of the chip (100, 400, 500, 600, 700, 800, 900, 1000, 1100).

13. The chip (100, 400, 500, 600, 700, 800, 900, 1000, 1100) of claim 10, wherein the BOX device (710, 810, 910, 1010, 1110) is an N-type metal-oxide semiconductor, NMOS, (110, 510, 820, 920), with BOX layer or a P-type metal-oxide semiconductor, PMOS, (410, 610), with the BOX layer, and the at least one ESD device (120, 420, 520, 620) comprises an N-type field oxide device, NFOD.

14. The chip (100, 400, 500, 600, 700, 800, 900, 1000, 1100) of claim 13, wherein the BOX device (710, 810, 910, 1010, 1110) is the diode-connected NMOS (110, 510, 820, 920) with BOX layer or the diode-connected PMOS (410, 610) with the BOX layer.

15. The chip (100, 400, 500, 600, 700, 800, 900, 1000, 1100) of claim 10, wherein the at least one ESD device (110, 510, 720, 820, 920, 1020) comprises a diode, an NMOS or a silicon controlled rectifier, SCR.
